Europäisches Patentamt

European Patent Office

Office européen des brevets

(19)

(11) Numéro de publication: **0 151 061**
A2

# (12) DEMANDE DE BREVET EUROPEEN

(21) Numéro de dépôt: 85400083.3

(22) Date de dépôt: 18.01.85

(51) Int. Cl.⁴: **G 01 R 13/40, G 01 R 13/00**

(30) Priorité: **26.01.84 FR 8401177**

(43) Date de publication de la demande: **07.08.85**
**Bulletin 85/32**

(84) Etats contractants désignés: **AT BE CH DE GB IT LI LU NL SE**

(71) Demandeur: **BUREAU ET LABORATOIRE D'ETUDES ET RECHERCHES INTER-SOCIETES "BLERIS", 2 rue Georgette Agutte, F-75018 Paris (FR)**

(72) Inventeur: **Arnoux, Daniel, 2 rue Georgette Agutte, F-75018 Paris (FR)**
Inventeur: **Genter, Claude, 2 rue Georgette Agutte, F-75018 Paris (FR)**
Inventeur: **Anton, Christian, 2 rue Georgette Agutte, F-75018 Paris (FR)**
Inventeur: **Forme, Jacques, 2 rue Georgette Agutte, F-75018 Paris (FR)**

(74) Mandataire: **Roger-Petit, Jean-Camille et al, OFFICE BLETRY 2, Boulevard de Strasbourg, F-75010 Paris (FR)**

(54) Dispositif d'affichage analogique quantifié à structure plane et appareil de mesure analogique comportant un tel dispositif d'affichage.

(57) Ce dispositif d'affichage comprend un substrat plat (2), une succession d'électrodes identiques (6) excitables sélectivement en fonction de la valeur de la grandeur mesurée, et au moins une échelle graduée (7). Pour faciliter la détermination de la valeur de la grandeur mesurée en combinaison avec au moins une électrode excitée de ladite succession d'électrodes identiques, l'échelle graduée (7) est située sur la face du substrat (2) portant ladite succession d'électrodes identiques (6) et comprend au moins une première électrode (9, 11) formant une graduation, des secondes électrodes (13-18) formant une première série de nombres associés à la graduation, et des troisièmes électrodes (13-18) formant une seconde série de nombres associés à la graduation, les premières secondes et troisièmes électrodes étant reliées électriquement à des bornes de sortie ($S_{23}$-$S_{25}$) pour leur excitation sélective.

Dispositif d'affichage analogique quantifié à structure plane et appareil de mesure analogique comportant un tel dispositif d'affichage.

La présente invention concerne un dispositif d'affichage analogique quantifié à structure plane pour appareil de mesure analogique ayant plusieurs calibres, comprenant un substrat plat, une succession d'électrodes identiques disposées côte-à-côte sur une face du substrat et excitables sélectivement en fonction de la valeur de la grandeur mesurée, au moins une échelle graduée adjacente à ladite succession d'électrodes identiques pour déterminer la valeur de la grandeur mesurée en combinaison avec au moins une électrode excitée de ladite succession d'électrodes identiques, l'échelle graduée étant située sur la face du substrat portant ladite succession d'électrodes identiques et comprenant au moins une première électrode formant une graduation, des secondes électrodes formant une première série de nombres associés à la graduation, et des troisièmes électrodes formant une seconde série de nombres associés à la graduation, les premières, secondes et troisièmes électrodes étant reliées électriquement à des bornes de sortie pour leur excitation sélective.

Il est déjà connu d'afficher sous une forme analogique quantifiée la valeur d'une grandeur mesurée, en allumant un plus ou moins grand nombre d'électrodes adjacentes ou une unique électrode parmi une succession d'électrodes identiques en forme de barres ou points, la valeur de la grandeur mesurée étant lue sur une échelle graduée en regard de la dernière des électrodes adjacentes allumées ou de l'unique électrode allumée. De tels dispositifs d'affichage analogique quantifié sont par exemple commercialisés par la Société BURROUGHS sous la dénomination "BARGRAPH". Quelle que soit la technologie utilisée pour l'affichage (à cristal liquide, à gaz, fluorescent, électroluminescent ou électrochimique), l'échelle de mesure est en général gravée, imprimée ou rapportée par un moyen quelconque sur la vitre ou sur le boîtier du disposi- tif d'affichage. Autrement dit, l'échelle graduée et les électrodes servant à visualiser la valeur de la mesure ne se trouvent pas dans le même plan. Il en résulte un risque d'erreur de lecture dû aux erreurs de parallaxe et/ou à la réfraction à travers la vitre du dispositif d'affichage. En outre, quand le dispositif d'affichage est destiné à un appareil de mesure ayant plusieurs calibres, s'il y a une échelle graduée unique avec chiffraison unique, l'utilisateur est contraint d'appliquer un coefficient à la valeur lue pour obtenir la valeur réelle de la grandeur mesurée. Cela entraîne un risque d'erreur supplémentaire, surtout si l'appareil de mesure comporte des calibres qui ne sont pas dans un rapport décimal, car, dans ce cas, le ou les coefficients devant être appliqués aux valeurs lues sont eux-mêmes non décimaux, ce qui complique encore plus la détermination de la valeur de la grandeur à mesurer. Si le dispositif d'affichage comporte plusieurs échelles graduées avec des chiffraisons différentes, les risques d'erreur n'en sont pas pour autant éliminés étant donné qu'il subsiste un risque de confusion entre les échelles graduées.

On connaît aussi des dispositifs d'affichage permettant d'obtenir un affichage numérique et un affichage analogique de la valeur d'une grandeur mesurée (voir par exemple les appareils commercialisés par la Société PHILIPS sous la dénomination "AUTOMATIC MULTIMETER PM 2519" ou les appareils commercialisés par la Société FLUKE sous la dénomination "Multimètre Analogique/ Numérique de poche série 70";voir aussi la publication "MACHINE DESIGN", vol.55, nᵒ 23, Octobre 1983, pages 8,9, Cheveland, Ohio, l'article intitulé "Rugged pocket multimeters first with analog and digital display"). Dans les appareils connus de mesure de ce type, l'affichage principal est l'affichage numérique, tandis que l'affichage analogique est surtout utilisé comme un indicateur de tendance permettant de mieux voir le sens d'évolution de la valeur de la grandeur à mesurer quand celle-ci n'est pas stable. D'ailleurs, dans les appareils connus de ce type, l'échelle graduée associée à l'affichage analogique est extrêmement sommaire, voire inexistante.

On connaît aussi (brevet anglais nᵒ 2 046 492, figure 2) un dispositif d'affichage qui comprend une succession d'électrodes

0151061

3

identiques 20 disposées côte-à-côte et excitables sélectivement en fonction de la valeur de la grandeur mesurée, une échelle graduée 25 comprenant au moins une première électrode 25, 36, 37 dont les traits 26 forment une graduation, des secondes électrodes 30 formant une première série de nombres associés à la graduation, et des troisièmes électrodes 35 formant une seconde série de nombres associés à la graduation, les premières, secondes et troisièmes électrodes étant reliées électriquement à des bornes de sortie pour leur excitation sélective. Dans ce brevet anglais, il s'agit d'afficher une même grandeur, par exemple une vitesse, dans l'un ou l'autre de deux systèmes d'unité, par exemple des kilomètres/heure et des miles/heure, et quel que soit le système d'unités choisi il n'y a qu'un seul calibre de mesure. Dans le brevet anglais n° 2 046 492, les nombres de l'une des deux séries de nombres ou chiffraisons sont entièrement distincts des nombres de l'autre série de nombre et entrelacés entre ces derniers de manière à éviter un chevauchement des nombres des deux séries de nombres et de leurs connexions. Du fait même de l'entrelacement des deux chiffraisons et du fait de l'emploi de deux systèmes d'unité différents pour mesurer la même grandeur, il est nécessaire de prévoir deux échelles graduées de longueurs différentes. L'une des échelles graduées est formée par l'électrode 25, tandis que l'autre échelle graduée est formée par l'électrode 25 et par les électrodes 36 et 37 qui prolongent l'électrode 25 à ses deux extrémités. Il est donc nécessaire de prévoir également d'autres électrodes 20 en correspondance avec les électrodes 36 et 37. Le nombre de points de mesure associés à la graduation la plus longue est donc plus grand que le nombre de points de mesure associés à la graduation la plus courte, ce qui entraîne une perte de résolution pour cette dernière. En outre, ce brevet anglais ne résoud pas le problème de l'affichage dans le cas d'un appareil de mesure analogique ayant plusieurs calibres.

La présente invention a donc pour but de résoudre le problème de l'affichage analogique quantifié pour un appareil de mesure analogique ayant plusieurs calibres, tout en éliminant les risques d'erreur qui étaient dûs auparavant aux coefficients multiplicateurs, et sans perte de résolution dans le cas où on prévoit deux graduations.

Le dispositif d'affichage analogique quantifié selon la présente invention est caractérisé en ce que la graduation comprend des traits principaux formés par des électrodes reliées électriquement entre elles, et des traits secondaires situés entre les traits principaux et formés par d'autres électrodes reliées électriquement entre elles, en ce que à chaque trait principal de la graduation, est associée au moins une électrode formant un nombre de la première série de nombres et un nombre de la seconde série de nombres, en ce que, à l'exception du zéro de l'échelle graduée qui est commun aux deux séries de nombres et qui est formé par une électrode unique, chaque nombre de la première série comprend au moins un segment d'électrode et chaque nombre de la seconde série comprend au moins un segment d'électrode, et en ce que les nombres des deux séries de nombres ont des segments communs d'électrode.

Ainsi, au moins deux chiffraisons sont associées à l'échelle graduée, la chiffraison appropriée pouvant être "allumée" selon le calibre utilisé de l'appareil de mesure auquel est associé le dispositif d'affichage, ce qui facilite grandement la détermination de la valeur de la grandeur mesurée. En outre, comme l'échelle graduée et la chiffraison associée se trouvent dans le même plan que ladite succession d'électrodes identiques, toute erreur de parallaxe est éliminée.

Le dispositif d'affichage de la présente invention peut en outre comporter, sur ladite face du substrat, au moins une quatrième électrode formant une autre graduation pouvant être sélectivement "allumée" selon le calibre utilisé. La première série de nombres peut être associée à la première graduation, tandis que la seconde série de nombres peut être associée à la seconde graduation, l'une ou l'autre des deux graduations et la chiffraison correspondante pouvant être sélectivement "allumée" selon le calibre utilisé.

Ainsi, dans le dispositif d'affichage de la présente invention, on peut avoir soit une unique graduation associée à deux chiffraisons, soit deux graduations associées chacune à une chiffraison respective, mais dans les deux cas les nombres des deux chiffraisons ont des segments communs d'électrodes. Dans le cas où il est prévu deux graduations, les deux graduations ont la même longueur. Les traits principaux des deux graduations sont communs aux deux graduations, et la seconde graduation comporte des traits secondaires formés par d'autres électrodes entrelacées avec les électrodes formant les traits secondaires de la première graduation. Puisque les deux graduations ont la même longueur, le même nombre de points de mesure (succession d'électrodes identiques) peut être associé aux deux graduations. Il n'y a donc pas de perte de résolution en passant d'un calibre à un autre et pas de décalage du "zéro" de l'échelle graduée, ce qui simplifie le circuit de commande d'affichage associé à la succession d'électrodes identiques qui sont excitables sélectivement en fonction de la valeur de la grandeur mesurée.

L'invention sera maintenant décrite en faisant référence aux dessins annexés sur lesquels :

la figure 1 montre la plaque avant d'un dispositif d'affichage à crital liquide conforme à la présente invention, et les liaisons électriques pour l'excitation sélective des électrodes de la plaque avant.

Les figures 2,3 et 4 montrent la forme de certaines des électrodes de la plaque avant de la figure 1.

Les figures 5$\underline{a}$, 5$\underline{b}$, 5$\underline{c}$ et 5$\underline{d}$ montrent les électrodes de la plaque arrière du dispositif d'affichage à cristal liquide, qui est associée à la plaque avant de la figure 1.

Les figures 6 et 7 illustrent deux exemples d'affichage.

La figure 8 est une vue en coupe transversale du dispositif d'affichage à cristal liquide de la présente invention.

La figure 9 est un diagramme montrant la forme d'onde des signaux de commande pour le dispositif d'affichage de la présente invention.

La figure 10 est le schéma par blocs d'un appareil de mesure comportant un dispositif d'affichage conforme à la présente invention.

Dans la suite de la description, on supposera que le dispositif d'affichage est du type à cristal liquide et que l'appareil de mesure auquel il est destiné à être incorporé est un multimètre comportant plusieurs calibres, par exemple les calibres 3, 9, 30, 90, 300 et 900, et plusieurs fonctions, par exemple ampèremètre et voltmètre continu et alternatif, ohmmètre, wattmètre, fréquencemètre, thermomètre, etc. On ne décrira pas certains détails du dispositif d'affichage à cristal liquide, comme par exemple les polariseurs et les couches réflectrices éventuelles, étant donné que ces détails dépendent du type d'afficheur à cristal liquide (à diffusion dynamique, à effet de champ, transmissif, transflectif, réflectif, etc.) et que de toute façon ces détails sont bien connus et ne sont pas utiles à la compréhension de la présente invention. On décrira donc seulement les éléments du dispositif d'affichage qui sont utiles à la compréhension de l'invention, en particulier les électrodes permettant de visualiser sélectivement deux échelles graduées et les chiffraisons correspondantes en fonction du calibre utilisé de l'appareil de mesure.

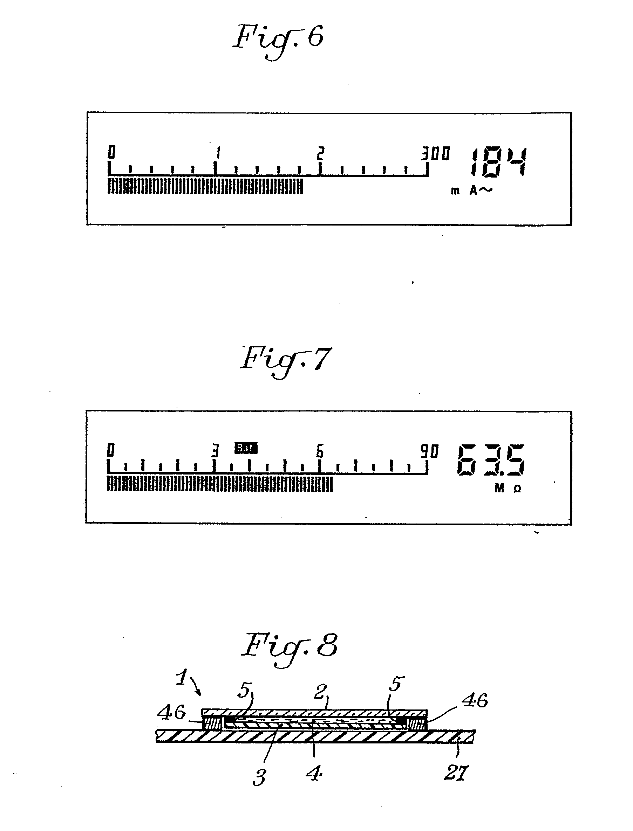

Comme cela est plus particulièrement visible sur la figure 8, le dispositif d'affichage 1 à cristal liquide comprend de façon connue une plaque avant 2, en une matière isolante et transparente, et une plaque arrière 3 en une matière isolante, entre lesquelles est disposé un cristal liquide 4 qui est contenu latéralement par un joint périphérique d'étanchéité 5. Des électrodes, qui seront décrites en détail plus loin, sont formées de façon connue sur la face inférieure de la plaque avant 2 et sur la face supérieure de la plaque arrière 3. De façon connue, les électrodes de la plaque avant 2 ont une forme ou un graphisme correspondant au dessin ou aux caractères à afficher et, lorsque des électrodes sélectionnées de la plaque avant 2 et de la plaque arrière 3 sont convenablement excitées de façon connue, elles provoquent un changement d'état localisé du cristal liquide, permettant ainsi de visualiser le dessin ou les caractères correspondant aux électrodes sélectionnées.

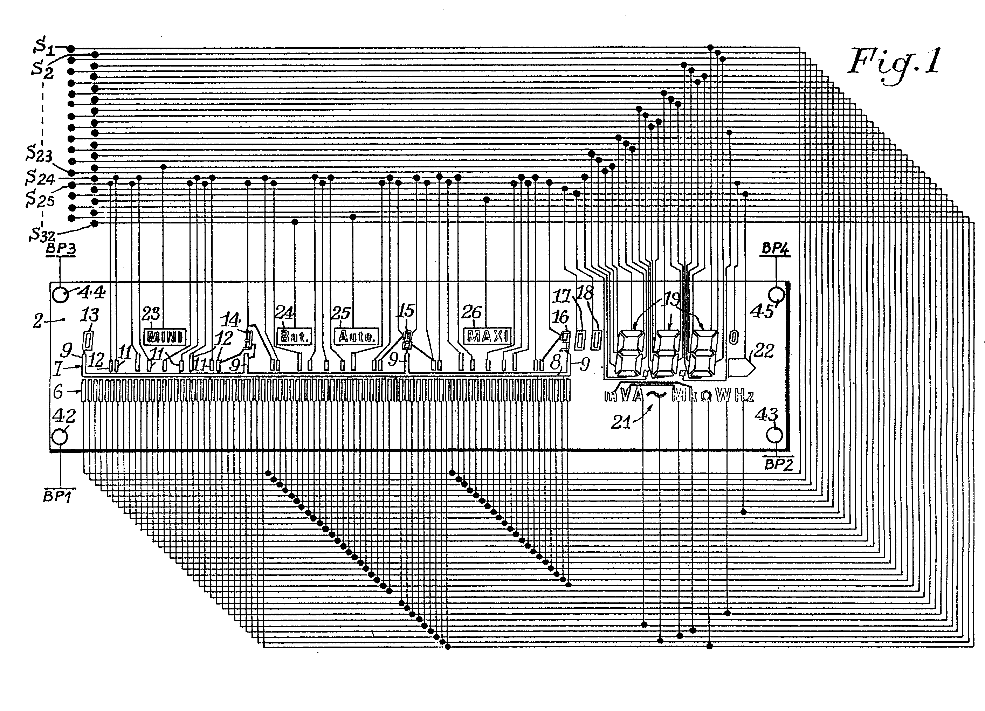

Dans la figure 1, les électrodes qui se trouvent sur la face inférieure de la plaque avant 2 sont représentées vues en transparence à travers la plaque avant 2. Parmi les électrodes de la plaque avant 2, est prévue une succession d'électrodes identiques 6, par exemple quatre vingt cinq électrodes en forme de barres verticales parallèles et régulièrement espacées, pour l'affichage analogique quantifié de la valeur de la grandeur mesurée. D'un côté de la succession d'électrodes 6 se trouve une échelle graduée 7. L'échelle 7 comprend une électrode ayant la forme d'une barre horizontale 8 à partir de laquelle s'étendent plusieurs segments verticaux 9 qui forment les traits principaux d'une graduation. Entre chaque paire de traits principaux 9 se trouvent quatre électrodes 11 qui forment des traits secondaires ou subdivisions de la graduation. Entre chaque paire de traits principaux 9 se trouvent également cinq autres électrodes 12, qui sont entrelacées avec les électrodes 11 et qui forment des traits secondaires d'une seconde graduation dont les traits principaux sont communs aux traits principaux 9 de la première graduation.

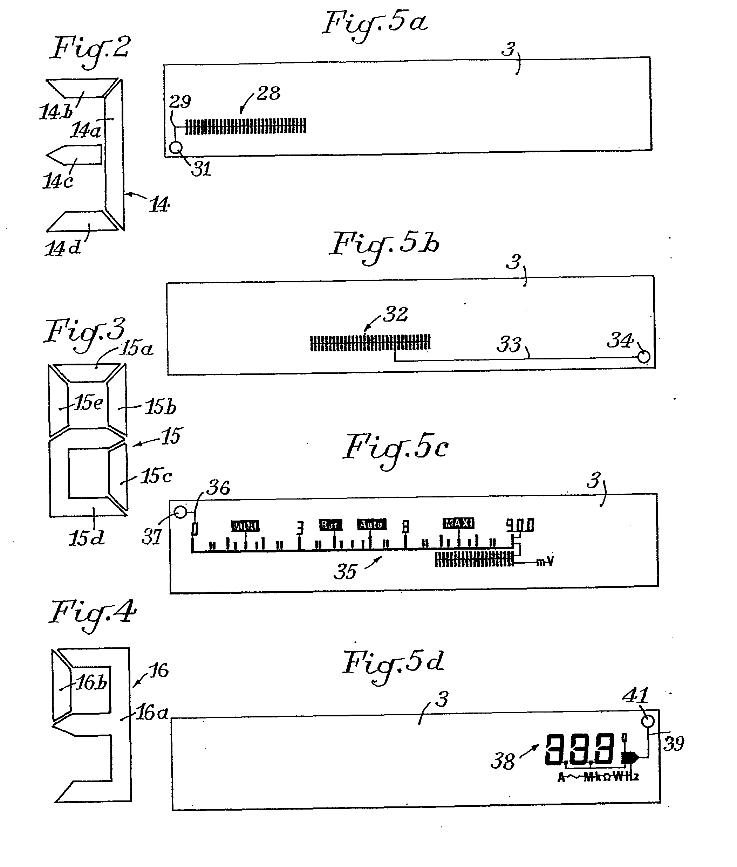

A chaque trait principal 9 est associée au moins une électrode 13, 14, 15 ou 16 permettant de visualiser des nombres associés respectivement à la première et à la seconde graduations. Dans l'exemple de réalisation décrit ici, l'électrode 13 est unique et forme le "0" de l'échelle graduée qui est commun aux deux graduations. Comme cela est visible dans la figure 2, l'électrode 14 comprend un segment d'électrode 14a qui est utilisé pour l'affichage du nombre "1" quand l'appareil de mesure fonctionne sur le calibre 3, 30 ou 300, et trois segments d'électrode 14b, 14c et 14d qui sont reliés électriquement entre eux comme montré sur la figure 1, mais qui sont isolés électriquement du segment d'électrode 14a, et qui sont utilisés, en combinaison avec ce dernier, pour l'affichage du nombre 3 quand l'appareil de mesure fonctionne sur le calibre 9, 90 ou 900. Comme montré sur la figure 3, l'électrode 15 comprend cinq segments d'électrode 15a à 15d, les segments 15a et 15d étant reliés électriquement l'un à l'autre comme montré dans la figure 1. Les segments d'électrode 15a, 15b et 15d sont utilisés pour l'affichage du nombre "2" quand l'appareil de mesure fonctionne sur le calibre 3, 30 ou 300, et les segments 15a, 15e, 15c et 15d sont utilisés pour l'affichage du nombre "6" quand l'appareil de mesure fonctionne sur le calibre 9, 90 ou 900. De même, comme montré sur la figure 4, l'électrode 16 comprend deux segments d'électrode 16a et 16b qui sont isolés électriquement l'un de l'autre. Le segment 16a est utilisé pour l'affichage du nombre "3" quand l'appareil fonctionne sur le calibre 3, 30 ou 300, tandis que les segments 16a et 16b sont utilisés en combinaison pour afficher le nombre "9" quand l'appareil de mesure fonctionne sur le calibre 9, 90 ou 900. A côté de l'électrode 16 se trouvent deux autres électrodes 17 et 18, chacune en forme de "0", l'électrode 17 étant utilisée quand l'appareil de mesure fonctionne sur le calibre 30 ou 90, tandis que l'électrode 18 est utilisée en combinaison avec l'électrode 17 quand l'appareil de mesure fonctionne sur le calibre 300 ou 900.

Sur la face inférieure de la plaque avant 2 sont également formées d'autres électrodes, en particulier un jeu d'électrodes 19 à sept segments, plus les points décimaux, pour l'affichage numérique de la valeur de la grandeur mesurée, un jeu d'électrodes 21 formant des lettres ou des symboles relatifs aux unités de mesure (m pour milli, V pour volt, A pour ampère, ∿ pour alternatif, M pour méga, k pour kilo, Ω pour ohm, W pour watt, Hz pour hertz, o pour degré et une flèche 22 pour indiquer éventuellement une fonction particulière), et d'autres électrodes 23, 24, 25 et 26 pour fournir des indications relatives au fonctionnement de l'appareil de mesure. L'électrode 23 (MINI) est utilisée pour indiquer que la valeur affichée de la grandeur mesurée est une valeur minimale parmi une série de valeurs mesurées. L'électrode 24 (Bat) est utilisée pour indiquer que la tension de la batterie incorporée dans l'appareil de mesure descend au-dessous d'un seuil prédéterminé. L'électrode 25 (Auto) est utilisée pour indiquer que l'appareil de mesure fonctionne dans un mode de sélection automatique des calibres. L'électrode 26 (MAXI) est utilisée pour indiquer que la valeur affichée de la grandeur mesurée est une valeur maximale parmi une série de valeurs mesurées.

Comme montré dans la figure 1, certains des segments d'électrode et certaines électrodes sont reliés électriquement entre eux par des dépôts métalliques conducteurs sur la face inférieure de la plaque avant 2. Au total, la face inférieure de la plaque avant 2 porte cent vingt huit segments d'électrodes, électrodes ou groupes d'électrodes qui sont reliés à l'extérieur de la plaque avant 2 à trente deux bornes de sortie S1 à S32 comme montré sur la figure 1 par des liaisons électriques qui peuvent être constituées par des trajets conducteurs formés sur une plaque à circuits imprimés 27 (figure 8), sur laquelle est fixé le dispositif d'affichage 1. Par exemple, les vingt troisième et cinquante cinquième électrodes de la succession d'électrodes 6, les segments d'électrode 8 et 9 de l'échelle graduée 7, l'électrode 13, le segment d'électrode 14a, les segments d'électrodes 15a et 15d, le segment d'électrode 16a et l'un des segments d'électrode du jeu d'électrodes 19 à sept segments sont reliés électriquement à la borne de sortie $S_{23}$; la vingt quatrième et la cinquante sixième électrodes de la succession d'électrodes 6, les électrodes 11, le segment d'électrode 15b et l'un des deux points décimaux de l'affichage numérique sont reliés électriquement à la borne de sortie $S_{24}$. La vingt cinquième et la cinquante septième électrodes de la succession d'électrodes 6, les électrodes 12, les segments d'électrode 15c et 15e, le segment d'électrode 16b et l'électrode en forme o (degré) sont reliés électriquement à la borne de sortie $S_{25}$.

Sur la face supérieure de la plaque arrière 3 sont formées plusieurs électrodes qui seront maintenant décrites en faisant référence aux figures 5a à 5d. La plaque arrière 3 comprend une première électrode 28 (figure 5a) qui correspond aux trente deux premières électrodes de la succession d'électrodes 6 et qui est reliée électriquement par une liaison 29 à une première plage conductrice 31 également formée sur la plaque arrière 3 ; une seconde électrode 32 (figure 5b) qui correspond aux trente deux électrodes suivantes de la succession d'électrodes 6 de la plaque avant 2 et qui est reliée électriquement par une liaison 33 à une seconde plage conductrice 34 ; une troisième électrode 35 (figure 5c) qui correspond aux vingt et une électrodes restantes de la succession d'électrodes 6, aux électrodes 8, 9, 11 à 18 et 23 à 26 et à une partie des électrodes 21 de la plaque avant 2 et qui est reliée électriquement par une liaison 36 à une troisième plage conductrice 37 également formée sur la plaque arrière 3 ; et une quatrième électrode 38 (figure 5d) qui correspond aux électrodes 19, à la partie restante des électrodes 21 et à l'électrode 22 de la plaque avant 2 et qui est reliée électriquement par une liaison 39 à une quatrième plage conductrice 41 également formée sur la plaque arrière 3. Comme montré sur les figures 5a à 5d, chacune des électrodes 28, 32, 35 et 38 comporte plusieurs segments d'électrode reliés électriquement entre eux et ayant des formes ou des graphismes identiques à ceux des électrodes correspondantes de la plaque avant 2. A titre de variante, chacune des électrodes 28, 32, 35 et 38 pourrait être constituée par une unique plage conductrice en prenant soin toutefois que cette plage conductrice ne coïncide pas avec des parties conductrices de la plaque avant 2 qui ne doivent pas être affichées. Les quatre plages conductrices 31, 34, 37 et 41 sont reliées électriquement à quatre plages conductrices 42, 43, 44 et 45, respectivement, qui sont formées sur la face inférieure de la plaque avant 2 et qui sont elles-mêmes reliées électriquement à quatre bornes de sortie BP1, BP2, BP3 et BP4, respectivement. Ainsi, toutes les sorties du dispositif d'affichage 1 se trouvent dans le même plan et peuvent être reliées électriquement aux circuits imprimés de la plaque 27 par des pièces de connexion 46 comme montré dans la figure 8.

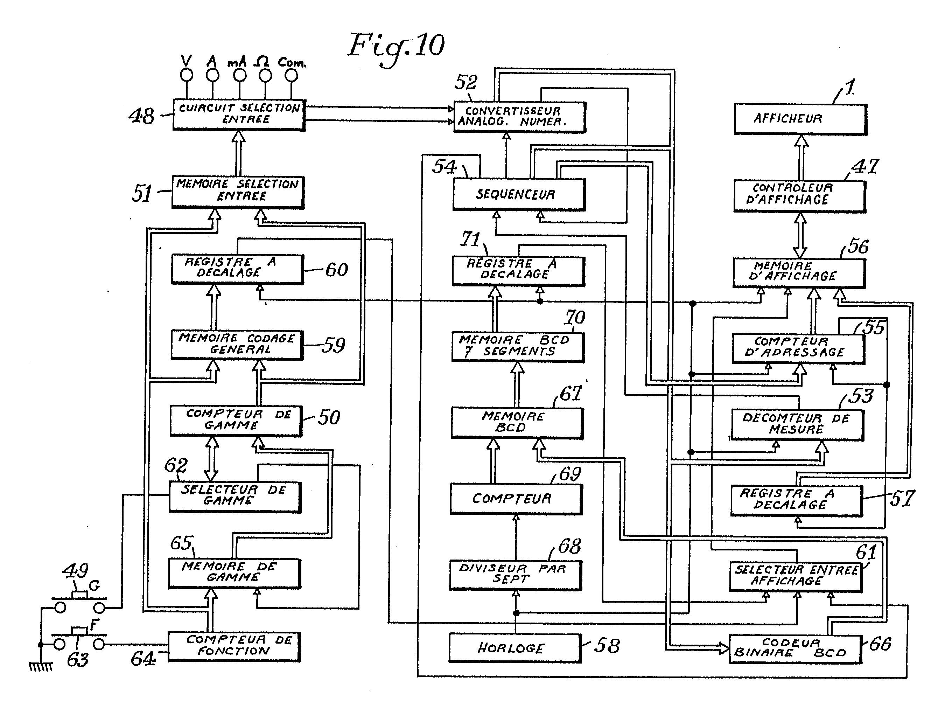

Dans l'exemple de réalisation qui a été décrit ci-dessus, il est prévu quatre électrodes 28, 32, 35 et 38 sur la plaque arrière 3. Cela permet de multiplexer (quadruplexer dans le cas présent) les cent vingt huit électrodes (compte tenu des connexions extérieures) de la plaque avant 2 et, par suite, de réduire à trente deux le nombre des connexions au contrôleur d'affichage 47 (figure 10) qui pilote le dispositif d'affichage 1. Bien entendu, on pourrait réaliser un multiplexage différent de celui qui est représenté sur la figure 1 en prévoyant un nombre plus grand ou plus petit d'électrodes sur la plaque arrière 3.

On notera que, en fonctionnement, quel que soit le calibre utilisé de l'appareil de mesure, les bornes de sortie $S_{23}$ et BP3 sont excitées de manière convenable pour "allumer" en permanence l'électrode 13 et les segments d'électrode 8, 9, 14$\underline{a}$, 15$\underline{a}$, 15$\underline{d}$ et 16$\underline{a}$. La borne de sortie $S_{24}$ est excitée en même temps que les bornes de sortie $S_{23}$ et BP3 quand l'appareil de mesure fonctionne sur le calibre 3, 30, 300 pour "allumer" les électrodes 11 et le segment d'électrode 15$\underline{a}$. La borne de sortie $S_{25}$ est excitée en même temps que les bornes de sortie $S_{23}$ et BP3 quand l'appareil de mesure fonctionne sur les calibres 9, 90 ou 900, pour "allumer" les électrodes 12 et les segments d'électrode 14$\underline{b}$, 14$\underline{c}$, 14$\underline{d}$, 15$\underline{c}$, 15$\underline{e}$ et 16$\underline{b}$.

Sur la figure 6 on a représenté à titre indicatif, l'échelle graduée qui est affichée lorsque l'appareil de mesure fonctionne sur le calibre 300mA∿, tandis que sur la figure 7, on a représenté l'échelle graduée qui est affichée lorsque l'appareil de mesure fonctionne sur le calibre 90MΩ. Sur les figures 6 et 7 on a également représenté à titre indicatif la valeur de la grandeur en cours de mesure sous forme analogique quantifiée et sous forme numérique.

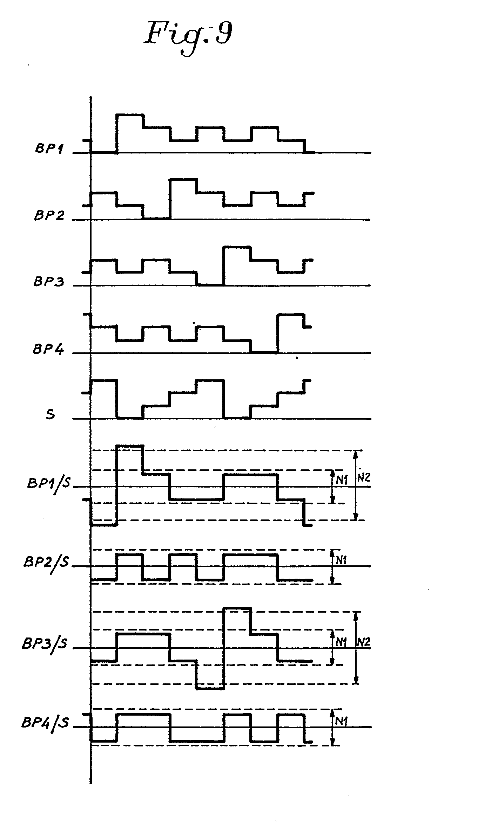

En service, le dispositif d'affichage 1 reçoit, par l'intermédiaire du contrôleur d'affichage 47 (figure 10) les signaux de commande permettant d'"allumer" ou d'"éteindre" sélectivement les cent vingt huit électrodes de la plaque avant 2, c'est-à-dire de visualiser ou d'effacer les symboles, caractères dessins correspondant à ces cent vingt huit électrodes. Ces signaux de commande comprennent, d'une part, les quatre signaux de commande des quatre électrodes 28, 32, 35 et 38 de la plaque arrière 3 et, d'autre part, les 32 signaux de commande des 32 groupes de quatre électrodes de la plaque avant 2, chaque électrode de chaque groupe correspondant à un segment identique d'électrode de l'une des quatre électrodes de la plaque arrière 3. Tous ces signaux de commande sont récurrents et ont un cycle élémentaire de huit phases successives, chaque électrode de la plaque arrière 3 étant activée durant deux phases successives. Chaque signal de commande attaquant une électrode de la plaque arrière 3 comporte la succession de niveaux 0-V pour les phases correspondant à l'électrode activée et la succession de niveaux 2V/3-V/3 pour les autres phases. Dans la partie supérieure de la figure 9, on a représenté les quatre signaux de commande correspondant aux quatre électrodes 28, 32, 35 et 38 de la plaque arrière 3. Ces quatre signaux sont respectivement désignés par BP1, BP2, BP3 et BP4, c'est-à-dire par les bornes auxquelles ils sont appliqués. On notera que le deuxième, le troisième et le quatrième signal de commande correspondent au premier signal de commande déphasé respectivement de deux, quatre et six phases.

Les signaux de commande appliqués aux électrodes de la plaque avant 2 varient avec l'affichage à obtenir. Lorsque l'électrode correspondant à une phase activée doit être allumée, la succession de niveaux V-0 lui est appliquée. Si elle doit être éteinte, la succession de niveaux V/3-2V/3 lui est appliquée. Ainsi, si dans un groupe d'électrodes de la plaque avant 2 on doit avoir l'allumage de celles qui correspondent aux électrodes 28 et 35 de la plaque arrière 3 et extinction de celles qui correspondent aux électrodes 32 et 38 de la plaque arrière 3, la succession des niveaux V-0-V/3-2V/3-V-0-V/3-2V/3 sera appliquée à la borne S correspondante comme indiqué en S dans la figure 9. Dans ce cas, les quatre signaux de commande apparaissant entre les électrodes 28, 32, 35 et 38 de la plaque arrière 3 et l'électrode S correspondante de la plaque avant 2 ont été représentés dans la partie inférieure de la figure 9 et sont respectivement désignés par BP1/S, BP2/S, BP3/S et BP4/S. Sur les quatre diagrammes correspondants, on a également représenté le niveau N1 assurant

13

l'extinction d'une électrode de la plaque avant 2 et le niveau N2 assurant son allumage avec le contrast optimal. Sur ces quatre diagrammes, on constate que seuls les signaux BP1/S et BP3/S appliqués aux électrodes de la plaque avant 2 qui sont associées aux électrodes 28 et 35 de la plaque arrière 3 ( BP1 et BP3) dépassent le niveau N2 et provoquent l'allumage des électrodes correspondantes, alors que les signaux BP2/S et BP4/S appliqués aux électrodes de la plaque avant 2 qui sont associées aux électrodes 32 et 38 de la plaque arrière 3 (BP2 et BP4) restent inférieurs au niveau N1 et ne provoquent donc pas l'allumage des électrodes correspondantes. Il apparaît en outre sur ces diagrammes que les valeurs moyennes des signaux sont nulles, ce qui est la condition nécessaire au bon fonctionnement de certains dispositifs d'affichage, en particulier des dispositifs d'affichage à cristal liquide.

L'appareil de mesure, dont le schéma par blocs est représenté sur la figure 10, comprend, outre le dispositif d'affichage 1 et le contrôleur d'affichage 47 déjà mentionnés, un circuit de sélection d'entrée 48 apte à recevoir au moins un signal d'entrée à mesurer qui est appliqué entre une borne commune "Com" et l'une des bornes d'entrée "V", "A", "mA" et "$\Omega$"; une touche de sélection de gammes 49; un compteur de gamme 50 qui réagit à l'actionnement de la touche de sélection de gamme 49; une mémoire de sélection d'entrée 51 qui est reliée à la sortie du compteur de gamme 50 et qui adapte le circuit de sélection d'entrée 48 à une gamme sélectionnée par la touche de sélection de gamme 49; un convertisseur analogique/numérique 52 qui est relié à la sortie du circuit de sélection d'entrée 48; un décompteur de mesure 53 qui est relié à la sortie du convertisseur analogique/numérique 52; un séquenceur 54 qui est relié à la sortie du décompteur de mesure 53; un compteur d'adressage 55 qui est relié à la sortie du séquenceur 54; une mémoire d'affichage 56, qui comporte 32 mots de quatre bits dont une première entrée est reliée à la sortie du compteur d'adressage 55 et dont la sortie est reliée au contrôleur d'affichage 47; un premier registre à décalage 57 un bit quatre positions à sorties parallèles, dont l'entrée est reliée à la sortie du compteur d'adressage 55 et dont la sortie est reliée à une seconde entrée de la mémoire d'affichage 56; et une horloge 58 dont la sortie est reliée à des entrées d'horloge du décompteur de mesure 53, du compteur d'adressage 55 et de la mémoire d'affichage 56.

Selon la présente invention, l'appareil de mesure comporte en outre une mémoire de codage général 59 qui est reliée à la sortie du compteur de gamme 50, un second registre à décalage 60 à sortie série, dont l'entrée d'horloge est reliée à la sortie de l'horloge 58 et dont l'entrée de données est reliée à la sortie de la mémoire de codage général 59, et un sélecteur d'entrée d'affichage 61 ayant une première entrée reliée à la sortie du séquenceur 54 et une seconde entrée reliée à la sortie du second registre à décalage 60, et dont la sortie est reliée à une troisième entrée de la mémoire d'affichage 56.

Pour la sélection automatique des gammes ou calibres de mesure, l'appareil de mesure peut comporter un sélecteur automatique de gamme 62 dont l'entrée est reliée à la touche de sélection de gamme 49 et dont la sortie est reliée au compteur de gamme 50. Dans le cas où l'appareil de mesure est un appareil multifonction, il peut en outre comporter une touche de sélection de fonction 63, un compteur de fonction 64 dont l'entrée est reliée à la touche de sélection de fonction 63 et dont la sortie est reliée à la mémoire de sélection d'entrée 51, et une mémoire de gamme 65 ayant une première entrée reliée à la sortie du compteur de fonction 64 et une seconde entrée reliée à la sortie du sélecteur de gamme 62, et dont la sortie est reliée au compteur de gamme 50.

Lorsque l'appareil de mesure est également prévu pour l'affichage numérique de la valeur de la grandeur mesurée, il comprend en outre un codeur BCD (binaire-codé-décimal) 66 qui est relié à la sortie du convertisseur analogique/numérique 52 et à la sortie du séquenceur 54, une mémoire BCD 67 à trois mots de quatre bits (chaque mot correspondant à l'une des trois électrodes du jeu d'électrodes 19 à sept ségments), qui a une première entrée reliée à la sortie du codeur BCD 66, un diviseur par sept 68 qui est relié à la sortie de l'horloge 58, un compteur binaire 69 à sorties parallèles, dont l'entrée est reliée à la sortie du diviseur par sept 68 et dont les sorties sont reliées à une seconde entrée de la mémoire BCD 67, une mémoire BCD sept segments 70 reliée à la sortie de la mémoire BCD 67, et un troisième registre à décalage 71 à sortie série ayant une entrée d'horloge reliée à l'horloge 58 et une entrée de données reliée à la sortie de la mémoire BCD sept segments 70, et dont la sortie est reliée à une troisième entrée du sélecteur d'entrée d'affichage 61.

On décrira maintenant le fonctionnement de l'appareil de mesure. L'état des électrodes allumées ou éteintes est fourni, sur interrogation du contrôleur d'affichage 47, par la mémoire d'affichage 56 qui comporte trente deux mots de quatre bits. Dans chaque mot, le bit de même poids est affecté à la même électrode 28, 32, 35 ou 38 de la plaque arrière 3, tandis que chacun des trente deux mots est affecté à l'un des trente deux groupes d'électrodes de la plaque avant 2.

La mémoire d'affichage 56 est chargée à partir de trois sources d'information :

1. Informations relatives à l'affichage analogique de la valeur de la grandeur mesurée.

2. Informations relatives à l'affichage numérique de la valeur de la grandeur mesurée.

3. Informations générales relatives aux autres affichages.

Le bit correspondant à chaque électrode est chargé dans la mémoire d'affichage 56 à l'adresse donnée par le compteur d'adressage 55.

On décrira maintenant successivement le chargement des informations relatives aux trois sources d'information susmentionnées.

Chargement des informations relatives à l'affichage analogique

La valeur à afficher de la grandeur mesurée est convertie sous forme numérique par le convertisseur analogique/numérique 52 et est chargée initialement dans le décompteur de mesure 53. Au démarrage du cycle de fonctionnement, la mémoire d'affichage 56 est mise à zéro, le compteur d'adressage 55 est chargé à l'adresse de départ, un état haut est appliqué à l'entrée des données de la mémoire d'affichage 56, et le registre à décalage 57 un bit quatre positions est chargé à "1" dans sa première position.

Pour démarrer le chargement des informations relatives à l'affichage analogique, les impulsions de l'horloge 58 sont appliquées au compteur d'adressage 55 qui adresse successivement les positions de la mémoire d'affichage 56. L'état haut sur l'entrée des données de la mémoire d'affichage 56 est enregistré dans cette dernière, dans la position de bit sélectionnée par le registre à décalage 57, à chaque impulsion de l'horloge 58. Pendant ce temps, le décompteur de mesure 53 est décrémenté à chaque impulsion de l'horloge 58. Lorsque la dernière adresse est inscrite dans la mémoire d'affichage 56, le débordement du compteur d'adressage 55 fait avancer d'une position de bit le registre à décalage, pointant dans la mémoire d'affichage 56 le bit de poids immédiatement supérieur. En même temps le compteur d'adressage 55 est rechargé à son adresse de départ.

Lorsque le décompteur de mesure 53 atteint zéro, le fonctionnement est arrêté. Le nombre de bits à l'état 'l' qui ont été chargés dans la mémoire d'affichage 56 pour l'allumage d'un nombre correspondant d'électrodes de la succession d'électrodes 6 de la plaque avant 2, est alors égal à la valeur chargée initialement dans le décompteur de mesure 55. A ce moment, l'entrée des données de la mémoire d'affichage 56 est ramenée à l'état bas.

<u>Chargement des informations relatives à l'affichage numérique</u>

La valeur à afficher de la grandeur mesurée est codée par le codeur BCD 66 et stockée dans la mémoire 67 à trois mots de quatre bits. Cette mémoire 67 est adressée par le compteur binaire à sorties parallèles 69 qui reçoit, par l'intermédiaire du diviseur par sept 68, les impulsions de l'horloge 58.

La sortie de la mémoire 67 adresse la mémoire 70 qui, pour chacune des adresses correspondant aux chiffres '0' à '9', fait apparaître sur sa sortie la combinaison des états commandant l'allumage de la première électrode à sept segments du jeu d'électrodes 19 correspondant au premier chiffre de la valeur numérique à afficher de la grandeur mesurée. Cette combinaison d'états est chargée dans le registre à décalage 71 à sortie série qui, à chaque impulsion de l'horloge 58, fournit à la mémoire d'affichage 56, adressée par le compteur d'adressage 55 et par le registre à décalage 57 , le niveau correspondant à l'état d'un des sept segments du chiffre à afficher. Au début du cycle d'affichage, le registre à décalage 57 est chargé pour pointer les bits relatifs à l'électrode 38 de la plaque arrière 3 associée au jeu d'électrodes à sept segments 19 de la plaque avant 2. D'autre part, au début du cycle d'affichage numérique, le séquenceur 54 charge le compteur d'adressage 55 à son adresse d'origine et le décompteur de mesure 53 à 21 (trois fois sept segments). Toutes les sept impulsions d'horloge, une nouvelle position de la mémoire 67 correspondant au chiffre suivant à afficher est adressée par le compteur 69. Le fonctionnement s'arrête lorsque le décompteur de mesure 53 atteint zéro. L'entrée des données de la mémoire d'affichage 56 est alors ramenée à zéro.

### Chargement des informations générales

Les informations générales comportent les symboles relatifs à l'affichage analogique (graduations 9, 11, 12, chiffraison 13 à 16 de l'échelle graduée 7 et les deux zéros 17 et 18 pour les facteurs décimaux de la chiffraison), les symboles relatifs à l'affichage numérique (les deux points décimaux), les symboles relatifs aux unités de mesure (V, A, $\Omega$, V, Hz, o et $\sim$), les symboles relatifs aux trois préfixes (m, M et k.) et les symboles fonctionnels relatifs aux modes de fonctionnement ou à la signalisation des fonctionnements anormaux ( MINI, MAXI, Auto et Bat). Les symboles autres que les symboles fonctionnels dépendent de la grandeur mesurée et de la gamme ou calibre selectionné.

La sélection de la fonction et la sélection de la gamme ou calibre sont effectuées respectivement au moyen de la touche de fonction 63 et de la touche de gamme 49. Chaque fois que la touche de fonction est actionnée, elle décrémente le compteur de fonction 64 et chaque fois que la touche de gamme 49 est actionnée elle décrémente le compteur de gamme 50. Chaque fois que le compteur de fonction 64 atteint zéro, il est rechargé à une valeur maximale correspondant au nombre de fonctions de l'appareil de mesure.

Chaque fois que le compteur de gamme 50 atteint zéro, l'appareil de mesure passe dans le mode "changement automatique de gamme". Ce mode est mémorisé dans le sélecteur de gamme 62 qui prend en charge la gestion du changement de gamme en décrémentant le compteur de gamme 50 lorsque la valeur de la grandeur mesurée dépasse la capacité maximale de mesure, et en incrémentant le compteur de gamme 50 lorsque la valeur de la grandeur mesurée est inférieure au tiers de cette capacité maximale.

Lors du fonctionnement en mode changement automatique de gamme, l'actionnement de la touche de gamme 49 ramène l'appareil de mesure dans le mode "changement manuel de gamme". Lors du passage de l'un à l'autre mode ou dans le mode changement automatique de gamme lorsque le compteur de gamme 50 atteint zéro, il est rechargé à la valeur maximale possible pour la fonction utilisée, cette valeur étant fournie par la mémoire de gamme 65 qui comporte autant de mots de quatre bits que de fonctions possibles et qui est adressée par le compteur de fonction 64.

Le compteur de fonction 64 et le compteur de gamme 50 adressent la mémoire de codage général 59 qui comporte, pour chaque combinaison fonction-gamme, un mot de 16 bits correspondant aux seize électrodes concernées pour l'affichage des symboles relatifs aux gammes et aux fonctions. Ce mot est chargé dans le registre à décalage 60 à sortie série et est transféré bit par bit dans la mémoire d'affichage 56 à chaque impulsion de l'horloge 58.

Au début du chargement des informations générales, le compteur d'adressage 55 et le registre à décalage 57 sont chargés par le séquenceur 54 aux valeurs adressant le premier bit à inscrire. De même, au début du chargement des informations générales, le décompteur de mesure est chargé à 16 par le séquenceur 54. Le chargement des informations générales s'arrête lorsque le décompteur de mesure 53 atteint zéro.

La sélection de la source d'information à mémoriser dans la mémoire d'affichage 56 (affichage analogique, affichage numérique ou affichage général) est effectuée par le sélecteur d'entrée d'affichage 61 qui reçoit sur ses trois entrées les signaux provenant respectivement du séquenceur 54, du registre à décalage 71 et du registre à décalage 60 et qui sélectionne ces signaux en fonction de l'état du séquenceur 54.

Dans un premier temps, le séquenceur 54 prend un premier état qui donne au convertisseur analogique/numérique 52 l'ordre d'effectuer une conversion. Lorsque cette dernière est terminée, le convertisseur 52 commande le passage à l'état suivant du séquenceur 54 qui, dans un deuxième temps, charge l'adresse d'origine de l'affichage analogique dans le compteur d'adressage 55 et qui sélectionne, par l'intermédiaire du sélecteur d'entrée d'affichage 61, un niveau haut pour les positions de bit de la mémoire d'affichage 56 correspondant aux électrodes à allumer de la succession d'électrodes 6.

Lorsque le décompteur de mesure 53 atteint zéro à la fin de ce deuxième temps, le séquenceur 54 passe à l'état suivant qui charge, dans un troisième temps, l'adresse d'origine de l'affichage numérique dans le compteur d'adressage 55 et qui sélectionne, par l'intermédiaire du sélecteur d'entrée d'affichage 61, la sortie du registre à décalage 71 pour l'allumage des segments appropriés des électrodes à sept segments du jeu d'électrodes 19.

Lorsque le décompteur de mesure 53 atteint zéro à la fin de ce troisième temps, le séquenceur 54 passe à l'état suivant qui, dans un quatrième temps, charge l'adresse d'origine de l'affichage général dans le compteur d'adressage 55 et qui sélectionne, par l'intermédiaire du sélecteur d'entrée d'affichage 61, la sortie du registre à décalage 60 pour l'allumage des électrodes appropriées relatives à la fonction et à la gamme utilisées. Lorsque le décompteur de mesure 53 atteint zéro à la fin du quatrième temps, le séquenceur revient à l'état initial et le cycle recommence.

Le convertisseur analogique/numérique 52, qui délivre sous forme numérique la valeur de la grandeur mesurée, est attaqué par le signal provenant du circuit de sélection d'entrée 48. Ce circuit 48, de conception classique, comporte des diviseurs de tension adaptant la tension d'entrée à l'étendue de mesure du convertisseur 52, des résistances shunt qui ramènent la mesure d'un courant à une mesure de tension, et une source de courant (batterie) qui délivre un courant qui, en passant dans une résistance à mesurer, fournit une tension au convertisseur 52. La sélection entre les diverses configurations d'entrée

20

dans le circuit de sélection d'entrée 48 est réalisée de manière classique par des commutateurs statiques dont les signaux de commande sont fournis par la mémoire de sélection d'entrée 51 qui est adressée par le compteur de fonction 64 et par le compteur de gamme 50.

Il va de soi que la forme d'exécution de la présente invention qui a été décrite ci-dessus a été donnée à titre d'exemple purement indicatif et nullement limitatif, et que de nombreuses modifications peuvent être apportées par l'homme de l'art sans pour autant sortir du cadre de la présente invention. C'est ainsi notamment que, bien que la présente invention ait été décrite en faisant plus particulièrement référence à un dispositif d'affichage à cristal liquide, elle s'applique également à des dispositifs d'affichage à structure plane faisant appel aux autres technologies rappelées dans le préambule de la description.

- REVENDICATIONS -
---------------

1. Dispositif d'affichage analogique quantifié à structure plane pour appareil de mesure analogique ayant plusieurs calibres, comprenant un substrat plat (2), une succession d'électrodes identiques (6) disposées côté-à-côte sur une face du substrat et excitables sélectivement en fonction de la valeur de la grandeur mesurée, au moins une échelle graduée (7) adjacente à ladite succession d'électrodes identiques (6) pour déterminer la valeur de la grandeur mesurée en combinaison avec au moins une électrode exitée de ladite succession d'électrodes identiques, l'échelle graduée (7) étant située sur la face du substrat (2) portant ladite succession d'électrodes identiques (6) et comprenant au moins une première électrode (9, 11) formant une graduation, des secondes électrodes (13-18) formant une première série de nombres associés à la graduation, et des troisièmes électrodes (13-18) formant une seconde série de nombres associés à la graduation, les premières, secondes et troisièmes électrodes étant reliées électriquement à des bornes de sortie ($S_{23}$-$S_{25}$) pour leur excitation sélective, caractérisé en ce que la graduation (9, 11) comprend des traits principaux formés par des électrodes (9) reliées électriquement entre elles, et des traits secondaires situés entre les traits principaux et formés par d'autres électrodes (11) reliées électriquement entre elles, en ce que à chaque trait principal (9) de la graduation, est associée au moins une électrode (13, 14, 15 ou 16) formant un nombre de la première série de nombres et un nombre de la seconde série de nombres, en ce que, à l'exception du zéro de l'échelle graduée qui est commun aux deux séries de nombres et qui est formé par une électrode unique (13), chaque nombre de la première série comprend au moins un segment d'électrode (14a ; 15a, 15b, 15d ; 16a) et chaque nombre de la seconde série comprend au moins un segment d'électrode (14a-14d ; 15a, 15c, 15d, 15e ; 16a, 16b), et en ce que les nombres des deux séries de nombres ont des segments communs d'électrode (14a ; 15a, 15d ; 16a).

2. Dispositif d'affichage selon la revendication 1, caractérisé en ce qu'il comprend en outre, sur ladite face du substrat (2), au moins une quatrième électrode (9, 12) formant une autre graduation.

3. Dispositif d'affichage selon la revendication 2, caractérisé en ce que les deux graduations (9, 11, 12) sont situées d'un même côté de la succession d'électrodes identiques (6).

4. Dispositif d'affichage selon la revendication 3, caractérisé en ce que ladite autre graduation (9, 12) comprend des traits principaux formés par des électrodes (9) qui sont communes à celles des traits principaux de la première graduation, et des traits secondaires formés par d'autres électrodes (12) entrelacées avec les électrodes (11) formant les traits secondaires de la première graduation.

5. Dispositif d'affichage selon l'une quelconque des revendications 1 à 4, caractérisé en ce qu'il comprend un jeu d'électrodes (21-26) excitables sélectivement et formant des symboles relatifs aux unités de mesure et aux modes de fonctionnement de l'appareil de mesure.

6. Dispositif d'affichage selon l'une quelconque des revendications 1 à 5, caractérisé en ce qu'il comprend un jeu d'électrodes (19) à sept segments formant des chiffres pour l'affichage numérique de la valeur de la grandeur mesurée.

7. Dispositif d'affichage selon l'une quelconque des revendications 1 à 6, du type à cristal liquide, comprenant une plaque avant (2) en une matière isolante transparente, une plaque arrière (3) en une matière isolante, et un cristal liquide (4) disposé entre les plaques avant et arrière, caractérisé en ce que ledit substrat est la plaque avant (2), en ce que toutes lesdites électrodes (9-26) sont formées sur la face inférieure de la plaque avant (2), et en ce qu'il comprend en outre au moins une électrode (28, 32, 35, 38) qui est formée sur la face supérieure de la plaque arrière (3) et qui est associée au moins à une partie des électrodes (9-26) de la plaque avant (2) pour provoquer un changement d'état localisé du cristal liquide (4) quand l'électrode de la plaque arrière est excitée en combinaison avec une électrode sélectionnée de la plaque avant.

8. Appareil de mesure comprenant un dispositif d'affichage selon l'une quelconque des revendications 1 à 7, un circuit de sélection d'entrée (48) apte à recevoir au moins un signal d'entrée à mesurer, une touche de sélection de gamme (49), un compteur de gamme (50) réagissant à l'actionnement de la touche de sélection de gamme (49), une mémoire de sélection d'entrée (51) reliée à la sortie du compteur de gamme (50) et adaptant le circuit de sélection d'entrée (48) à une gamme sélectionnée par la touche de gamme (49), un convertisseur analogique/numérique (52) relié à la sortie du circuit de sélection d'entrée (48), un décompteur de mesure (53) relié à la sortie du convertisseur analogique/ numérique (52), un séquenceur (54) relié à la sortie du décompteur de mesure (53), un compteur d'adressage (55) relié à la sortie du séquenceur (54), une mémoire d'affichage (56) ayant une première entrée reliée à la sortie du compteur d'adressage (55), un premier registre à décalage (57) dont l'entrée est reliée à la sortie du compteur d'adressage (55) et dont la sortie est reliée à une seconde entrée de la mémoire d'affichage (56), une horloge (58) dont la sortie est reliée à des entrées d'horloge du décompteur de mesure (53), du compteur d'adressage (55) et de la mémoire d'affichage (56), et un contrôleur d'affichage (47) dont l'entrée est reliée à la sortie de données de la mémoire d'affichage (56) et dont la sortie est reliée au dispositif d'affichage (1), caractérisé en ce qu'il comporte en outre une mémoire de codage général (59) reliée à la sortie du compteur de gamme (50), un second registre à décalage (60) ayant une entrée d'horloge reliée à la sortie de l'horloge (58) et une entrée de données reliée à la sortie de la mémoire de codage général (59), et un sélecteur d'entrée d'affichage (61) ayant une première entrée reliée à la sortie du séquenceur (54) et une seconde entrée reliée à la sortie du second registre à décalage (60), et dont la sortie est reliée à une troisième entrée de la mémoire d'affichage (56).

9. Appareil de mesure selon la revendication 8, caractérisé en ce qu'il comprend en outre un sélecteur automatique de gamme (62) dont l'entrée est reliée à la touche de sélection de gamme (49) et dont la sortie est reliée au compteur de gamme (50).

10. Appareil de mesure selon la revendication 9, caractérisé en ce qu'il comprend en outre une touche de sélection de fonction (63), un compteur de fonction (64) dont l'entrée est reliée à la touche de sélection de fonction (63) et dont la sortie est reliée à la mémoire de sélection d'entrée (51) et à la mémoire de codage général (60), et une mémoire de gamme (65) ayant une première entrée reliée à la sortie du compteur de fonction (64) et une seconde entrée reliée à la sortie du sélecteur de gamme (62), et dont la sortie est reliée au compteur de gamme (50).

11. Appareil de mesure selon l'une quelconque des revendications 8 à 10, caractérisé en ce qu'il comprend en outre un codeur binaire-codé-décimal (66) relié à la sortie du convertisseur analogique/numérique (52) et à la sortie du séquenceur (54), une mémoire binaire-codé-décimal (67) ayant une première entrée reliée à la sortie du codeur binaire-codé-décimal (66), un diviseur par sept (68) relié à la sortie de l'horloge (58), un compteur (69) dont l'entrée est reliée à la sortie du diviseur par sept (68) et dont la sortie est reliée à une seconde entrée de la mémoire binaire-codé-décimal (67), une mémoire binaire-codé-décimal sept segments (70) reliée à la sortie de la mémoire binaire-codé-décimal (67), et un troisième registre à décalage (71) ayant une une entrée d'horloge reliée à l'horloge (58) et une entrée de données reliée à la sortie de la mémoire binaire-codé-décimal sept segments (70), et dont la sortie est reliée à une troisième entrée du sélecteur d'entrée d'affichage (61).

Fig.1

2/5

*Fig.2*

*Fig.5a*

*Fig.3*

*Fig.5b*

*Fig.5c*

*Fig.4*

*Fig.5d*

## Fig.6

```
0          1          2        300    184
 ┃┃┃┃┃┃┃┃┃┃┃┃┃┃┃┃┃┃┃┃┃┃┃┃┃┃┃┃      m A~
```

## Fig.7

```
0          3   [Bat]   6          90    63.5
 ┃┃┃┃┃┃┃┃┃┃┃┃┃┃┃┃┃┃┃┃┃┃┃┃┃┃┃┃┃┃┃       M Ω
```

## Fig.8

0151061

4/5

## Fig.9

BP1

BP2

BP3

BP4

S

BP1/S — N1 N2

BP2/S — N1

BP3/S — N1 N2

BP4/S — N1

Fig.10